# Europäisches Patentamt

# European Patent Office

# Office européen des brevets

(19)

(11) Publication number: **0 047 121 B1**

(12) **EUROPEAN PATENT SPECIFICATION**

(45) Date of publication of patent specification: **30.04.86**

(51) Int. Cl.⁴: **B 41 M 5/26, G 11 C 13/04**

(21) Application number: **81303866.8**

(22) Date of filing: **25.08.81**

(54) **Imaging process.**

(30) Priority: **25.08.80 US 181269**

(43) Date of publication of application:
**10.03.82 Bulletin 82/10**

(45) Publication of the grant of the patent:
**30.04.86 Bulletin 86/18**

(84) Designated Contracting States:
**DE GB NL**

(56) References cited:
**EP-A-0 003 262**
**US-A-3 753 705**
**US-A-4 084 966**
**US-A-4 139 853**

**IEEE SPECTRUM, vol. 15, no. 8, August 1978,**
**New York, US R.A. BARTOLINI et al. "Optical**
**disk system emerge", pages 20-28**

(73) Proprietor: **XEROX CORPORATION**
**Xerox Square - 020**
**Rochester New York 14644 (US)**

(72) Inventor: **Vincett, Paul S.**
**RD1**
**Grand Valley Ontario, LON 1G0 (CA)**
Inventor: **Sharp, James H.**
**215 Richmond Road**
**Oakville Ontario, L6H 1L8 (CA)**
Inventor: **Pundsack, Arnold L.**
**RR 5**
**Georgetown Ontario, L7G 4S8 (CA)**

(74) Representative: **Goode, Ian Roy et al**
**European Patent Attorney c/o Rank Xerox**
**Limited Patent Department Rank Xerox House**
**338 Euston Road**
**London NW1 3BH (GB)**

## Description

This invention relates to an imaging process which includes selectively exposing to light an imaging member which comprises a monolayer of particles in a softenable layer. The invention is particularly concerned with an imaging process of the kind which includes selectively exposing an imaging member to light with an energy density of at least 5 millijoules per square centimeter, the imaging member comprising a substrate, a softenable layer on said substrate and a monolayer of particles embedded in said softenable layer spaced apart from said substrate, said particles being less than a wavelength of light from each other, and said exposing being conducted in the absence of an electric field, and being such that the particles struck by the light are heated and soften the softenable material thereby forming a detectable open space in the monolayer which exposes the substrate to view.

An imaging member of the kind specified is described in US Patent 4 084 966. In use, such an imaging member is exposed to a sufficiently large amount of energy (exposure duration between about 10 and $10^5$ microseconds) to cause simultaneous migration and agglomeration of the particles which sink into the substrate. This agglomeration leaves transparent areas which were previously occupied by the individual particles. Other such imaging members are described in US Patents 3 520 681, 3 740 223, 3 753 705 and 4 029 502. However, in all of these processes, a large amount of energy is consumed making such processes inappropriate for application to an optical disc medium.

In US Patent 3 753 705 the imaging member consists of a layer of agglomerable particles in an imagewise hardenable-softenable layer. One suitable material for the hardenable-softenable layer is a custom synthesized copolymer of styrene and hexylmethacrylate. Imagewise exposure with sufficient ultra violet radiation (exposure duration for about 10 seconds) causes hardening of the exposed portions by virtue of a chemical reaction which takes place within the copolymer. The remaining portions of the layer are then softened by heat, vapour or liquid treatment to allow the particles to agglomerate.

In a different mode of imaging with such an imaging member as mentioned above, there is described in US Patent 3 966 465 to Bean a multilayer imaging member having a clear layer residing on a substrate absent migration material and overcoated with a layer of softenable material containing migration material either dispersed throughout the softenable layer or in a monolayer configuration. An electrical latent image is created on the member with electrostatic charges having a density sufficient to cause migration of the migration material from the layer containing the migration material into the clear layer which acts as a "circulation layer". The penetration of the migration material at the interface of the clear circulation layer in which it was originally contained. This process also consumes a considerable amount of energy and also requires the creation of an electrical latent image by selectively charging areas of the imaging member.

An optical disc storage medium desirably retains the recorded information for a long period of time, to the extent of being archival. However, typical optical disc materials are not sufficiently stable to retain an image for a period of time long enough to be considered archival. There is needed a simple, inexpensive, archival optical disc storage medium which also utilizes only a small amount of energy for making a discernible mark easily readable by the systems known in the art.

The present invention is intended to provide an imaging process of the kind specified which results in an improved image quality while using considerably less light energy to create the image than the known processes. The imaging process of the invention is characterised in that the exposing beam is a narrow beam of light with an exposure duration of between 0.01 and 0.1 microseconds, which beam creates turbulent motion in the softenable material to disperse said particles away from the center of said narrow beam of light.

The process of this invention provides an imaging process which provides an archival quality image in an optical disc storage medium. The optical disc storage medium is readable by either reflective or transmissive means.

It has now been discovered that the above described migration imaging member can be imaged with a small amount of light energy, in the absence of an electrical field, to produce an effect on the migration material which provides a high resolution image with contrast sufficient for purposes of an optical disc. In summary, the imaging process utilized in this invention is one which employs a small amount of energy concentrated in a small area thus softening the softenable material so as to create only a small amount of turbulent motion in the softenable layer, thereby dispersing a portion of the particles from the layer into the softenable material by moving these particles away from the center of said narrow beam of light and under the remaining monolayer. By way of contrast with US 3 753 705, the present process uses a considerably shorter exposure to light of a longer wavelength, so excluding the possibility of a chemical reaction which would lead to hardening of the storage medium material.

A process in accordance with the present invention will now be described, by way of example, with reference to the accompanying drawings, in which:—

Figure 1 represents a partially schematic drawing representing a preferred embodiment of an imaging member according to this invention.

Fig. 2 shows the imaging member of Fig. 1 being imaged in a preferred mode hereof by reason of exposure to a burst of radiation from a laser source.

Fig. 3 shows the imaged member of Fig. 2 transmitting a portion of the light falling upon the surface of the member.

Fig. 4 shows the imaged member of Fig. 2 reflecting a portion of light radiation falling upon the surface of the member, said member containing a reflective layer on the surface of the substrate.

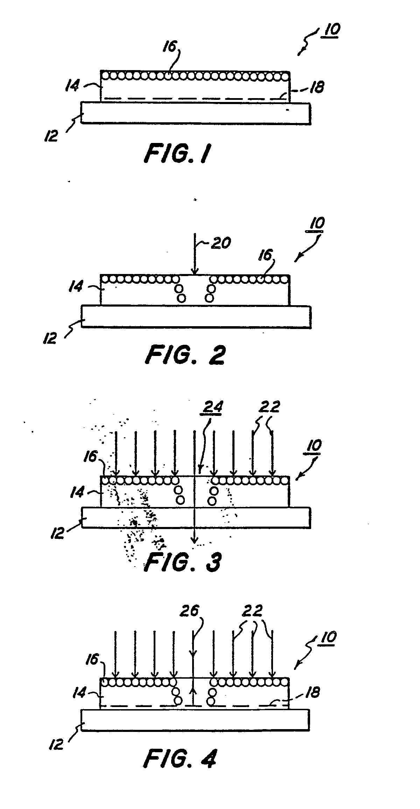

Referring now to Figure 1, there is shown a schematic drawing of one embodiment of an imaging member 10 according to the invention comprising substrate 12, softenable layer 14 which contains at its upper surface a monolayer 16 of migration material. Substrate 12 optionally contains a light reflective layer 18 at the interface of the softenable layer 14 and substrate 12.

The substrate of member 10 may be of any suitable material in the form of a strip, sheet, plate, coil, cylinder, drum, endless belt or disc as desired. The substrate may be substantially transparent to allow for exposure from either side or to permit the resultant imaged member to transmit or reflect light depending upon the end use intended.

Softenable layer 14 may comprise one or more layers of softenable materials, typically a plastic or thermoplastic material which is softenable when heated as a result of light absorption by monolayer 16 in accordance with this invention. Such material will soften by radiation means such as is produced by a laser source. Sudden softening of a portion of the surface of the softenable layer causes turbulent motion of the softened portion thereby dislodging migration material 16 from its layered configuration in the area struck by light.

Exemplary softenable materials include Staybelite Ester 10, commercially available from Hercules Powder Co., a partially hydrogenated (approximately 50 percent) rosin glycerol ester, Ethocel, an ethylcellulose material commercially available from Dow Chemical Co., polyxylene adipate, polyhexamethylene, sebacate, polyvinyl alcohol, polyvinylbenzyltrimethyl ammonium chloride, and others. A typical exemplary softenable material is a custom synthesized 80/20 mole percent copolymer of styrene and hexylmethacrylate having a molecular weight of about 45,000 (weight average).

Other suitable materials for softenable layer 14 are stated in the prior art as, for example, in U.S. 3,598,644 to Goffe et al.

Any suitable migration material 16 can be utilized whether electrically photosensitive or non-electrically photosensitive since the imaging process does not depend upon the generation of charged particles or the use of electrical fields. However, it has been found that a particularly preferred material for migration material 16 is selenium because of its stability and ease of fabrication in the member. Typically, the particles have a diameter in the range of from about .1 micron to about .5 micron. It has been found generally that particles above the size of about .5 micron do not yield an optimum resolution and may show a reduction in image density as compared to images having particles less than about .5 micron in diameter. Other particles which can be utilized in layer 16 are selenium tellurium alloys, arsenic triselenide and tin. Other examples of migration material suitable in the process of this invention are found in U.S. Patent 3,520,681.

Reflective layer 18 is typically aluminum. Reflective materials have been utilized in optical disc technology in the past and are familiar to those engaged in the art of optical disc construction. Such prior art materials can be employed herein. Layer 18 enables increased light reflexion and thus reflection contrast between exposed and unexposed areas as will be more fully disclosed below. Typically reflective layer thickness is in the range of about 50 to 100 Angstroms as in the prior art of optical discs.

Figure 2 illustrates the imaging process of this invention wherein an extremely narrow beam of light is directed toward the surface of migration imaging member 10. In Figure 2, light beam 20 impinges upon the surface of softenable layer 14 thus causing it to soften and by the process of softening, causing turbulent motion within at least the top portion of the body of layer 14. The turbulent motion carries with it particles of migration material from layer 16 which disperse laterally and in depth into softenable layer 14, thereby creating a detectable open space in the otherwise semi-continuous layer 16 and exposing substrate 12 to view. There is thus provided an imaged member without the use of electrical fields. It is also noted that the image produced by removal of particles from layer 16 is principally the result of particle migration into the softenable material. The dispersion of the particles of layer 16 is sufficient to create an image contrast by a difference in absorption between the imaged area struck by light beam 20 and the unimaged areas.

Since the amount of light employed to image the member may be concentrated in a small area and the amount of softening of the softenable layer is confined to a small space, extremely small portions of imaging member 10 can be imaged by accurately directed light beams and such spaces can be positioned extremely close to each other thereby providing suitable operation for such apparatus as optical disc data storage means addressable and readable by means of light.

An exposure of an area on the imaging member having a diameter of submicron and larger produces images of dispersed particles in the softenable layer having high resolution. The size of the images produced on the imaging member is generally related to the total energy deposited on the member. Energy densities in the range of at least about 5 millijoules per square centimeter and higher energy levels have been found to be satisfactory.

The glass transition temperature ($T_g$) of the softenable material is also a significant factor in the sensitivity of the imaging member. Obviously, the materials having lower $T_g$ will provide greater sensitivity because they will soften at lower temperatures thus dispersing the particles of the migration layer. Softenable materials having a $T_g$ in the range of from about 30°C to about 100°C are preferred because of the favourable sensitivity obtained by their use without significant loss of handling and storage properties. However, materials having a wide $T_g$ range are useful in the present invention.

The light source may be, for example, in the form of a pulse from a laser, said pulse typically having a duration of from .01 microseconds to about .1 microseconds. Since energy density in the area of an image from a light source such as a laser is gaussian in nature, the intensity is greatest at the image centre. Because of this energy pattern, it has been found that the resolution obtained by the process of this invention may be greater than the image size of the exposure. Accordingly, the process of this invention provides image resolution highly suitable for optical data storage devices and use in optical data systems. The effect of the dispersion of the migration material and the softenable layer by the action of light in accordance with this invention provides a readable image in the imaging member such as by light transmission through the member or by light reflection wherein the substrate of the imaging member is provided with a light reflective layer. Optical disc memory systems are well known in the art and the imaging member of this invention can be employed easily in substitution of optical storage media now employed. While normally, such optical storage media utilize ablation of a layer through the use of light energy, the process of this invention utilizes a smaller amount of energy to merely disperse small particles into a softenable layer. There is thus provided an improved data storage system wherein an electronic device capable of translating optical signals into electrical signals and consequently into intelligible knowledge utilizing an optical storage medium is improved wherein the improvement comprises the migration imaging member of this invention, the imaging process described herein and the reading of such images made in accordance with this invention by either light reflection from the imaging member or light transmission through said imaging member.

In Figure 3, there is shown schematically the operation of the imaged member of Figure 2 when exposed to light. Light beams 22 are shown impinging upon the surface of imaged member 10. Layer 16 provides a level of absorption of light beams 22 different from that provided by imaged area 24. In area 24, the impinging light beams 22 are allowed to proceed through the open area of layer 16 to substrate 12 which, in this instance, is transparent, thus allowing transmission of that portion of light beam 22 proceeding through the imaged portion 24. It has been found that transmission contrast densities of about 1.5 have been achieved when utilizing selenium particles in layer 16 as described above, while slightly lower contrast is found in the reflective mode.

In Figure 4, there is shown schematically the operation of the imaged member of Figure 2 wherein a reflective layer 18 is included in the imaging member 10. A portion of light beams 22 is reflected from reflective area 18 directly back toward the source of the beam as indicated by the opposing arrows on beam 26.

The imaging member described in Figure 1 is easily fabricated by means known in the prior art. For example, a monolayer of selenium particles or other material evaporated and condensed on the surface of the softenable material is described in U.S. Patent 3,598,644, referred to above and incorporated herein by reference. In this method, the material to be evaporated is placed in a suitable chamber with an outlet and condensing tower whereby vapor of the material is emitted through an outlet and directed toward the surface of softenable material 14 residing on substrate 12. By controlling the temperature of evaporation and the amount allowed to condense on the surface of softenable layer 14, one can control the particle size and density of the material of migration layer 16. In addition, the temperature of softenable material 14 is also controlled so as to provide the optimum coating. The optimum configuration of layer 16 is a monolayer of closely spaced individual particles of migration material. A monolayer provides maximum light scattering for the amount of material available. A more detailed description of such layer may be found in the above-mentioned US patents 3,966,465 and 3,598,644.

Materials of layers 16 and 14 are chosen so as to react to the radiation intended to be used whereby the softenable layer 14 will soften by radiation thereby dispersing the particles of layer 16. Layer 16 absorbs most of the radiation employed when the light and materials are properly coordinated. Thus, while having no relationship to the electrical photosensitivity of the material, it is noted that light energy is absorbed for the purpose of heat generation, and thus, in this way light absorption is important in the choice of materials. Since total energy absorbed is related to time and intensity, these two factors are determinative. A short time period of high intensity radiation is optimum.

Further, the softenable material in layer 14 is chosen so as to have low thermal conductivity. The turbulent motion need only occur to a depth of about 2 to 3 times the diameter of the particles in layer 16. Thus, the thickness of layer 14 is usually in the range of from about .3 to about 5 microns with a preferred thickness in the range of from about 1 to about 3 microns. While thicker layers of softenable material in layer 14 are usable, such use of greater amounts of softenable material is considered inefficient.

An alternative method of fabrication of the imaging member of Fig. 1 is to utilize a type of cascade development wherein the particles of layer 16 are cascaded across the surface of softenable layer 14 while layer 14 is in the hardened state. When thoroughly coated with a uniform monolayer of particles, layer 14 is then uniformly softened whereby the particles residing on the surface sink into the softenable material and imbed just below the surface of layer 14. When performed properly, one uniform coating of particulate material in a monolayer is sufficient to establish a usable imaging member 10. As is known in the prior art as indicated, for example, by U.S. Patent 3,598,644, the monolayer of particles does not cover 100 percent of the surface area of the imaging member. However, because of the particle size and proximity of the particles to each other, satisfactory image densities are obtained. The practical result of such configuration is a concentration of material in a monolayer which, when disturbed, forms an image contrast.

Experience has shown that the above-described imaging member is capable of extremely high resolution even though layer 16 is particulate. Thus, the particles of layer 16 are not considered as independent light absorbers but must be treated as interacting with the softenable material in the small spaces between each particle. Such small spaces between the particulate members of layer 16 are generally smaller than a wavelength of light and are thus not considered as optical "holes" which would otherwise cause unwanted transmission of light. Because of the small amount of space between particulate members of layer 16, the attached drawings do not indicate the space between the particles.

### Example I

An imaging member is prepared by utilizing a 75 micron thick sheet of Mylar, a polyethylene terephthalate polymer commercially available from the E. I. duPont de NeMours & Company, Inc., which is coated with a 2 micron thick layer of Staybelite Ester 10. Onto the layer of Staybelite Ester 10 there is placed a layer of selenium particles by means of vacuum evaporation whereby there is condensed on the surface of the resin ester a monolayer of particulate vitreous selenium particles having a diameter of about .3 microns. The particles sink into the resin layer to a position immediately below the surface thereof to form a monolayer.

The imaging member is exposed to radiation produced by a dye laser emitting a wavelength of 488 nanometers with a focus on the surface of the imaging member to produce a beam size of 45 microns. A 1 microsecond pulse is utilized at a power of 500 mW corresponding to an energy density of 30 mJ/cm$^2$. The radiation produced a transparent image area in the layer of selenium of about 45 microns. The image has a contrast density in excess of 1 in the blue and green region of the light spectrum.

### Example II

The procedure of Example I is repeated with the exception that the power is reduced to 250 mW. In the area of the imaging member struck by the radiation, the image appeared bluish in transmitted light and was semi-transparent.

### Example III

An imaging member is prepared as described above with the exception that the softenable material is a copolymer made of an 80/20 mole ratio blend of styrene and hexylmethacrylate, which copolymer has a glass transition temperature above Staybelite Ester 10. The particle size of the particles in the migration layer is approximately .3 microns. The imaging member is imaged with a blue laser beam (441.6 nm) of about 10 mW which radiation was passed through an electro-optic modulator so as to produce a pulse length of .1 microsecond. The beam is focused to a diameter on the surface of imaging member of about .8 micron. An image is produced on the imaging member having a diameter of 1.1 microns.

### Claims

1. An imaging process which indicates selectively exposing an imaging member to light with an energy density of at least 5 millijoules per square centimeter, the imaging member comprising a substrate (12), a softenable layer (14) on said substrate and a monolayer of particles (16) embedded in said softenable layer spaced apart from said substrate, said particles being less than a wavelength of light from each other, and said exposing being conducted in the absence of an electric field, and being such that the particles struck by the light are heated and soften the softenable material thereby forming a detectable open space in the monolayer which exposes the substrate to view, characterised in that the exposing beam is a narrow beam of light with an exposure duration of between 0.01 to 0.1 microseconds, which beam creates turbulent motion in the softenable material to disperse said particles away from the center of said narrow beam of light.

2. The process of claim 1 wherein the particles comprise selenium, and the material of the softenable layer is a copolymer of styrene and hexamethylmethacrylate.

3. The process of claim 1 wherein the particles are non-electrically photosensitive.

4. The process of any one of claims 1 to 3 wherein the light source is a laser.

5. The process of any one of claims 1 to 4 wherein the glass transition temperature of the material of the softenable layer is in the range of from about 30°C to about 100°C.

6. The process of any one of claims 1 to 5 wherein the particles have a diameter in the range of 0.1 micron to 0.5 microns.

7. The process of any one of claims 1 to 6 wherein the substrate is transparent and the image formed provides light transmission through said member.

8. The process of any one of claims 1 to 6 wherein the substrate comprises a light reflective layer and the image formed provides reflected light from said substrate.

9. The process of any one of claims 1 to 8 wherein said turbulent motion extends into said softenable layer to a depth of from about 2 to about 3 times the diameter of said particles.

10. An optical data storage medium formed by the process of any one of claims 1 to 9.

## Patentansprüche

1. Abbildungsverfahren, welches das selektive Belichten eines Abbildungsteiles mit Licht mit einer Energiedichte von wenigstens 5 Millijoule pro cm² umfaßt, wobei der Abbildungsteil einen Träger (12), einer erweichbare Schicht (14) auf dem genannten Träger und eine mit Abstand von dem genannten Träger angeordnete, in der genannten erweichbaren Schicht eingebettete Monoschicht aus Teilchen (16) umfaßt, welche Teilchen weniger als eine Wellenlänge des Lichts voneinander entfernt sind, und wobei das genannte Belichten in der Abwesenheit eines elektrischen Feldes durchgeführt wird und derart ist, daß die vom Licht getroffenen Teilchen erhitzt werden und das erweichbare Material erweichen und dabei einen den Träger der Betrachtung aussetzenden feststellbaren offenen Raum in der Monoschicht bilden, dadurch gekennzeichnet, daß der belichtende Strahl ein dünner Lichtstrahl mit einer Belichtungsdauer von 0,01 bis 0,1 Mikrosekunden ist, welcher Strahl turbulente Bewegung in dem erweichbaren Material bewirkt, um die genannten Teilchen weg vom Zentrum des genannten dünnen Lichtstrahls zur verteilen.

2. Verfahren nach Anspruch 1, in welchem die Teilchen Selen enthalten und das Material der erweichbaren Schicht ein Kopolymer aus Styrol und Hexamethylmethacrylat ist.

3. Verfahren nach Anspruch 1, in welchem die Teilchen Nichtelektrisch lichtempfindlich sind.

4. Verfahren nach einem der Ansprüche 1 bis 3, in welchem die Lichtquelle ein Laser ist.

5. Verfahren nach einem der Ansprüche 1 bis 4, in welchem die Glas-Übergangstemperatur des Materials der erweichbaren Schicht im Bereich von ungefähr 30°C bis ungefähr 100°C liegt.

6. Verfahren nach einem der Ansprüche 1 bis 5, in welchem die Teilchen einen Durchmesser im Bereich von 0,1 Mikron bis 0,5 Mikron aufweisen.

7. Verfahren nach einem der Ansprüche 1 bis 6, in welchem der Träger transparent ist und das geformte Abbild die Lichtübertragung durch den genannten Teil hindurch ermöglicht.

8. Verfahren nach einem der Ansprüche 1 bis 6, in welchem der Träger eine lichtreflektierende Schicht enthält und das geformte Abbild von dem genannten Träger reflektiertes Licht erzeugt.

9. Verfahren nach einem der Ansprüche 1 bis 8, in welchem die genannte turbulente Bewegung sich in die erweichbare Schicht bis zu einer Tiefe von ungefähr 2 bis ungefähr 3 mal dem Durchmesser der genannten Teilchen hinein erstreckt.

10. Optisches Datenspeicherungsmedium, das durch das Verfahren nach irgendeinem der Ansprüche 1 bis 9 hergestellt ist.

## Revendications

1. Procédé de reproduction d'images, qui comporte l'exposition sélective d'un élément d'imagerie à la lumière avec une densité d'énergie d'au moins 5 millijoules par centimètre carré, l'élément d'imagerie comportant un substrat (12), un couche pouvant ramollir (14) sur le substrat et une monocouche de particules (16) noyées dans la couche pouvant ramollir espacée du substrat, les particules étant à moins d'une longueur d'onde de lumière les unes des autres, et l'exposition étant conduite en l'absence d'un champ électrique, et étant telle que les particules frappées par la lumière sont échauffées et ramollissent le matériau pouvant ramollir, d'où la formation d'un espace ouvert détectable dans la monocouche qui expose le substrat à la vue, caractérisé en ce que le faisceau d'exposition est un faisceau étroit de lumière avec une durée d'exposition comprise entre 0,01 et 0,1 microseconde, faisceau qui crée un mouvement turbulent dans le matériau pouvant ramollir de manière à disperser les particules pour les éloigner du centre du faisceau étroit de lumière.

2. Procédé selon la revendication 1, caractérisé en ce que les particules sont constituées de sélénium, et le matériau de la couche pouvant ramollir est un copolymère de styrène et d'hexaméthylméthacrylate.

3. Procédé selon la revendication 1, caractérisé en ce que les particules sont non électriquement photosensibles.

4. Procédé selon l'une quelconque des revendications 1 à 3, caractérisé en ce que la source lumineuse est un laser.

5. Procédé selon l'une quelconque des revendications 1 à 4, où la température de transition vitreuse du matériau de la couche pouvant ramollir est comprise entre environ 30°C et environ 100°C.

6. Procédé selon l'une quelconque des revendications 1 à 5, où les particules ont un diamètre compris entre 0,1 micron et 0,5 micron.

7. Procédé selon l'une quelconque des revendications 1 à 6, où le substrat est transparent et l'image formée fournit une transmission de la lumière par l'intermédiaire de l'élément.

8. Procédé selon l'une quelconque des revendications 1 à 6, où le substrat comporte une couche réfléchissant la lumière et l'image formée fournit de la lumière réfléchie par le substrat.

9. Procédé selon l'une quelconque des revendications 1 à 8, où le mouvement turbulent s'étend dans la couche pouvant ramollir jusqu'à une profondeur comprise entre environ 2 et environ 3 fois le diamètre des particules.

10. Milieu de stockage optique de données formé par le procédé de l'une quelconque des revendications 1 à 9.

FIG. 1

FIG. 2

FIG. 3

FIG. 4